# EUROPÄISCHE PATENTANMELDUNG

(11) **EP 0 844 490 A1**
(43) Veröffentlichungstag der Anmeldung: **27.05.1998**
(21) Anmeldenummer: 97119721.5
(22) Anmeldetag: 11.11.1997
(51) Int. Cl.: G01R 33/46

(54) **Verfahren zur Strukturanalyse und Verifizierung von Strukturen chemischer Verbindungen**

(30) Priorität: 13.11.1996 DE 19646906
(71) Anmelder: BASF AKTIENGESELLSCHAFT, 67056 Ludwigshafen (DE)
(72) Erfinder: Will, Martin, Dr., 68259 Mannheim (DE); Fachinger, Winfried, 55413 Trechtingshausen (DE)
(74) Vertreter: Isenbruck, Günter, Dr.

(57) **Zusammenfassung**

Bei einem Verfahren zur Strukturanalyse einer chemischen Verbindung durch Vergleich von mit der chemischen Verbindung gemessenen Meßwertsignalen und ermittelten Meßwerten wird ein erstes Meßwertsignal für zumindest eine erste Verbindung einer zu der angenommenen Struktur ähnlichen Struktur mit derselben ersten Teilstruktur, jedoch mit einem anderen Substituenten Sv (anstelle des Substituenten Sa der untersuchten Verbindung), an der Substitutionsposition erzeugt; ein zweites Meßwertsignal erzeugt, das den Unterschied der Meßwerte einer zweiten Sv-substituierten Verbindung zu einer unsubstituierten (dritten) Verbindung darstellt; ein drittes Meßwertsignal erzeugt, das den Unterschied der Meßwerte einer vierten Sa-substituierten zu einer unsubstituierten Verbindung darstellt; ein viertes Meßwertsignal aus den ersten drei Meßwertsignalen erzeugt und das gemessene Meßwertsignal und das vierte Meßwertsignal miteinander verglichen.

## Beschreibung

Die Erfindung betrifft Verfahren zur Strukturanalyse chemischer Verbindungen. Insbesondere bezieht sich die Erfindung auf Analyseverfahren und -methoden, die auf NMR-Messungen chemischer Verbindungen beruhen.

In der Analytik chemischer Verbindungen besteht häufig die Aufgabe, eine vermutete chemische Struktur einer oder mehrerer Verbindungen oder eines Gemisches zu verifizieren. Wenn man die Verbindungen der zu verifizierenden Struktur nicht zum Vergleich hat, muß die Verifizierung durch Vergleich mit Daten bekannter Verbindungen erfolgen.

Es werden heute Strukturvalidierungen mit Hilfe von NMR-Informationen durchgeführt. Dabei können die gemessenen NMR-Daten mit bekannten Daten von mittels des HOSE-Codes erfassten bzw. kodierten Teilstrukturen verglichen werden. HOSE-Codes beschreiben Teilstrukturen in Sphären. Bei 3-Sphären HOSE-Codes sind alle Atome um ein zentrales Atom erfaßt, die bis zu 3 Bindungen von diesem entfernt sind. (vergl. W. Bremser, Anal. Chem. Acta Vol. 103, 1978, S. 355 - 365, "HOSE - a novel substructure code"). Ein anderes Verfahren vergleicht die gemessenen NMR-Daten mit Daten von Verbindungen, die gleiche Substitutionen am gleichen Grundkörper, z.B. einem Benzolring, haben. Dieses System wird auch Inkrementsystem genannt.

Beide Systeme haben Nachteile. Häufig reichen die Daten der bekannten Teilstrukturen nicht für eine akzeptable Sicherheit der Verifizierung aus. Bei Aromaten können die meta- und para-ständigen Substituenten oft nicht berücksichtigt werden. Inkrementbasierte Vorhersagen versagen oft bei orthosubstituierten Aromaten, weil sterische Effekte nicht berücksichtigt werden können. Außerdem addieren sich kleine Abweichungen der Inkremente bei der Berechnung von hochsubstituierten Verbindungen zu signifikanten Fehlern.

L. Chen und W. Robien haben in J.Chem.Inf.Comput.Sci 33,441-446 und 447-452 Methoden zur automatischen Analyse von Substituent-induzierten Differenzen der chemischen Verschiebung bei ¹³C-NMR-Spektren beschrieben. Sie haben auf effiziente MCSS-Algorithmen und trickreiche Strategien hingewiesen. Jedoch sind diese Verfahren für die Analyse von Verbindungen mit vollkommen oder weitgehend unbekannter Struktur beschrieben worden. Analysezeiten nämlich Rechenzeiten von 3 Stunden bzw. 50 Minuten wurden berichtet. Diese Verfahren sind für routinemäßige Verifizierungen von Strukturen zu langsam und ihre Durchführung ist zu aufwendig. Es müssen erhebliche Programmierarbeiten geleistet werden, um die trickreichen Strategien durchzuführen.

Aufgabe der Erfindung ist es, ein Verfahren zur Strukturanalyse und Strukturverifizierung für chemische Verbindungen anzugeben, das einfach und schnell durchgeführt werden kann, vorhandene Daten nutzt und mit bekannten Programmen arbeiten kann.

Diese Aufgabe wird erfindungsgemäß durch Verfahren gelöst, wie sie in den Ansprüchen definiert sind. Bevorzugte Ausführungsformen sind in den Unteranspüchen definiert und in den Beispielen erläutert.

Erfindungsgemäß wurde ein Verfahren zur Strukturanalyse einer chemischen Verbindung durch Vergleich von mit der chemischen Verbindung gemessenen Meßwerten bzw. gemessenen Meßwertsignalen und ermittelten Meßwerten (ermittelten Meßwertsignalen) verbessert. Insbesondere wurde eine größere Genauigkeit bzw. Zuverlässigkeit der Verfahrensergebnisse erzielt. Dies wurde bewerkstelligt durch folgende Merkmale:
a. Die untersuchte Verbindung hat eine angenommene Struktur mit einer ersten Teilstruktur T1 mit einer Substitutionsposition und einer daran befindlichen Substitution Sa. Mit der untersuchten Verbindung wurde die Messung durchgeführt und ein gemessenes Meßwertsignal erzeugt.
b. Ein erstes Meßwertsignal für zumindest eine erste Verbindung einer zu der angenommenen Struktur ähnlichen Struktur mit derselben ersten Teilstruktur T1, jedoch mit einem anderen Substituenten Sv an der Substitutionsposition, wird ermittelt. Statt Sa ist also Sv an der Substitutionsposition vorhanden.
c. Ein zweites Meßwertsignal wird ermittelt, das den Unterschied der Meßwerte einer zweiten Verbindung mit einer zweiten Teilstruktur T2, die in der ersten Teilstruktur T1 vorhanden ist und ebenfalls die Substitutionsposition aufweist und an dieser den Substituenten Sv trägt, und einer dritten Verbindung darstellt, die mit der zweiten Verbindung übereinstimmt, jedoch in der Substitutionsposition den Substituenten Sv nicht trägt. Dieses zweite Meßwertsignal stellt gleichsam den Beitrag von Sv zum Meßergebnis mit der zweiten Verbindung gegenüber der nicht mit Sv substituierten zweiten Verbindung dar.
d. Ein drittes Meßwertsignal wird ermittelt, das den Unterschied der Meßwerte einer vierten Verbindung mit einer dritten Teilstruktur T3, die in der ersten Teilstruktur T1 vorhanden ist und ebenfalls die Substitutionsposition aufweist und an dieser den Substituenten Sa trägt, und einer fünften Verbindung darstellt, die mit der vierten Verbindung übereinstimmt, jedoch in der Substitutionsposition den Substituenten Sa nicht trägt. Auch hier stellt das dritte Meßsignal den Beitrag von Sa zum Meßergebnis an der mit Sa substituierten Verbindung gegenüber der insoweit unsubstituierten Verbindung dar.

Anstelle der zweiten und dritten Meßsignale selbst, die ja Inkremente bzw. Meßwert-Unterschiede darstellen, können natürlich auch die diesen zugrundeliegenden Meßwerte bzw. Meßwertsignale eingesetzt werden. Auch im übrigen sind Angaben zum Ablauf der Berechnungen konzeptionell zu verstehen; andere Methoden, die auf demselben Prinzip der Inkrementkompensation zwischen teilweise übereinstimmenden Strukturen beruhen, können eingesetzt werden.

Die zweite und dritte Teilstruktur (T2 und T3) können die gleichen sein. In den Beispielen sind sie gleich. Sie sind dort Benzolringe.
e. Ein viertes Meßwertsignal wird dadurch ermittelt, daß das erste Meßwertsignal mit Hilfe des zweiten Meßwertsignals und des dritten Meßwertsignals auf ein der angenommenen Struktur entsprechendes Meßwertsignal korrigiert wird,
f. Das gemessene Meßwertsignal und das vierte Meßwertsignal werden miteinander verglichen.

Das erfindungsgemäße Verfahren läßt sich zur Verifizierung angenommener Strukturen hervorragend einsetzen. Es ist jedoch erfindungsgemäß auch möglich, das Verfahren bei Analysen chemischer Verbindungen einzusetzen, die eine unbekannte oder weitgehend unbekannte Struktur haben. Dann wird das Verfahren automatisch mehrfach für die verschiedenen möglichen Strukturen durchgeführt, und die Struktur mit der geringsten Abweichung oder der geringsten Summe von Abweichungen (bei ¹³C-NMR: Summe der Abweichungen der zu den einzelnen C-Atomen gehörenden Verschiebungen) wird angezeigt.

Die verschiedenen möglichen Strukturen, die verifiziert werden sollen, können automatisch von einem Strukturgenerator generiert werden. Eine automatische Generierung möglicher Strukturen kann beispielsweise durch Überlagerung von bekannten Teilstrukturen erfolgen. Für die automatisch generierten möglichen Strukturen wird das erfindungsgemäße Verfahren zur Verifizierung von angenommenen Strukturen durchgeführt, bei dem die Struktur mit der geringsten Summe der Abweichungen als zutreffende Struktur ermittelt wird. Damit eignet sich das erfindungsgemäße Verfahren für die automatische Strukturaufklärung, die als isolierbare Einzelschritte die Analyse zur Erzeugung von Meßwerten, die Strukturgenerierung und Strukturvalidierung umfaßt. Die Verifizierung der angenommenen Strukturen ist ein Schlüsselschritt in der automatischen Strukturaufklärung und erfordert eine schnelle und präzise Vorhersage von Spektren, um aus der mitunter großen Zahl möglicher Strukturen die zutreffende Struktur zu ermitteln. Aufgrund seiner hohen Genauigkeit der Spektrenvorhersage ist das erfindungsgemäße Verfahren besonders für die automatische Strukturaufklärung geeignet.

Bei einem bevorzugten Verfahren wird zumindest ein erstes normiertes Meßwertsignal ermittelt, indem von dem entsprechenden ersten Meßwertsignal das Inkrement für die Substitution Sv entsprechend der Differenz der Meßwerte der zweiten und der dritten Verbindungen abgezogen wird, und zu dem ersten normierten Meßwertsignal das Inkrement für die Substitution Sa entsprechend der Differenz der Meßwerte der vierten und fünften Verbindung addiert wird. Besonders bewährt hat sich dabei ein Verfahren, bei dem eine Mehrzahl von ersten Meßwertsignalen für eine entsprechende Mehrzahl verschiedener erster Verbindungen ermittelt wird, für jede der verschiedenen ersten Verbindungen für deren jeweilige Substitution Sv das zugehörige zweite Meßwertsignal ermittelt wird und von dem ersten Meßwertsignal abgezogen wird und aus den erhaltenen Einzelergebnissen ein Mittelwert als gemitteltes erstes normiertes Meßwertsignal gebildet wird. Überraschenderweise führt diese Mittelwertbildung auch dann zu einer Verbesserung der Ergebnisse, wenn keine Auswahl (etwa unter chemischen Gesichtspunkten) unter den zur Verfügung stehenden Teilstrukturen erfolgt.

Zu dem so durch Mittelung gebildeten gemittelten ersten normierten Meßwertsignal wird das dritte Meßwertsignal hinzugefügt, um das vierte Meßwertsignal zu erhalten.

Weiterhin ist ein Verfahren bevorzugt, bei dem man das erste Meßwertsignal und die Teilsignale des zweiten Meßwertsignals und des dritten Meßwertsignals bzw. die zweiten Meßwertsignale und die dritten Meßwertsignale selbst automatisch als digitales Signalwort aus einem Rechner aufgrund der Eingabe der Teilstrukturen und Substitutionen ermittelt.

Die gemessenen Meßwertsignale, die ersten, zweiten und dritten Meßwertsignale bzw. deren Teilsignale sind vorzugsweise ¹³C-NMR-Signale, insbesondere die jeweiligen chemischen Verschiebungen, für die entsprechenden Verbindungen bzw. Substituenten. Die Substitution Sa bezüglich des betrachteten C-Atoms ist dabei vorzugsweise eine entfernte Substitution, für Aromaten häufig eine Substitution am vierten Atom (4. Sphäre) ausgehend vom betrachteten Atom als dem ersten, insbesondere eine p-Substitution an einer aromatischen Verbindung. Die Erfindung ist jedoch auch bei aliphatischen Verbindungen anwendbar, häufig mit Teilstrukturen mit bekannten Ergebnissen, die Atome bis zu 2 Bindungen vom untersuchten Atom aufweisen. Besonders geeignet ist das erfindungsgemäße Verfahren für Situationen, bei denen Information zu Strukturen mit HOSE-Codes der vierten Sphäre noch nicht bekannt sind. Dabei werden Informationen, insbesondere NMR-Analyseergebnisse, bevorzugt ¹³C-NMR-Analyseergebnisse von Teilstrukturen mit 2 oder 3 bekannten Atom-Sphären, verarbeitet.

Bewährt hat sich bei den mit ¹³C-NMR-Spektren bzw. Daten solcher Spektren arbeitenden Verfahren besonders, mit der Strukturkodierung nach dem HOSE-Code zu arbeiten. Mit dieser Kodierung von Strukturen können alle Verbindungen bzw. Teilstrukturen eindeutig erfaßt und eventuell vorhandene Werte (Verschiebungen) können rasch aus der Datenbank ermittelt werden.

Ein weiteres erfindungsgemäßes Verfahren dient der Strukturanalyse von chemischen Verbindungen. Dabei wird die chemische Verbindung einem Analyseverfahren zur Erzeugung eines Meßwertes als Grundlage der Erzeugung eines gemessenen Meßwertsignals unterzogen. Das gemessene Meßwertsignal wird mit einem ermittelten Meßwertsignal verglichen. Dabei wird das ermittelte Meßwertsignal wie oben angegeben bestimmt.

Bei allen Meßwertsignalen kann es sich um übliche elektrische Meßwertsignale handeln. Zur Erzielung hoher Arbeitsgeschwindigkeiten eignen sich indessen besonders digital kodierte Meßwertsignale, insbesondere solche aus einem digitalen Speicher, wie etwa einer Datenbank. Bei dieser bevorzugten Ausführungsform wird die Suche nach dem passenden Meßwertsignal schnell und einfach.

Die folgenden Beispiele enthalten bevorzugte Ausführungsformen und bevorzugte Einzelmerkmale der Erfindung, ohne diese hierauf zu beschränken.

### Beispiel 1

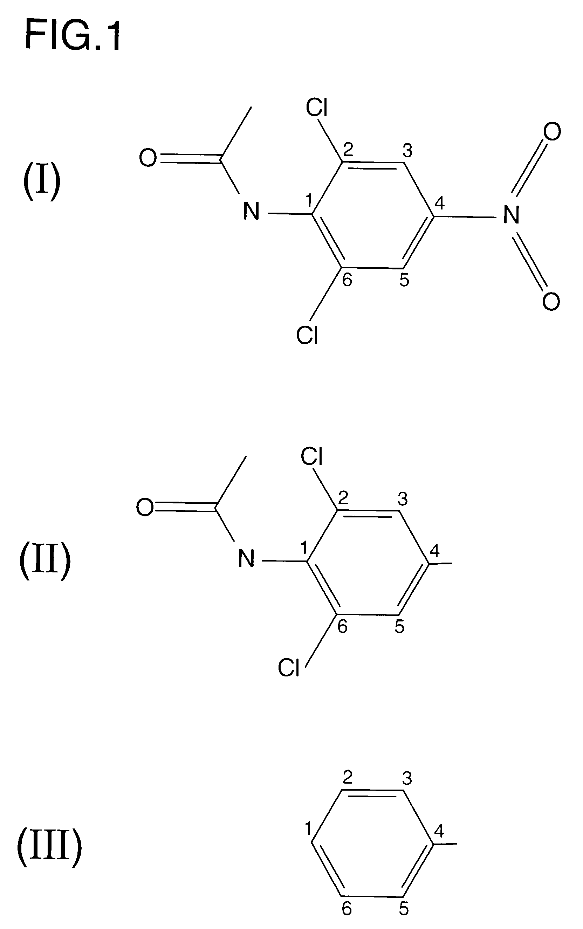

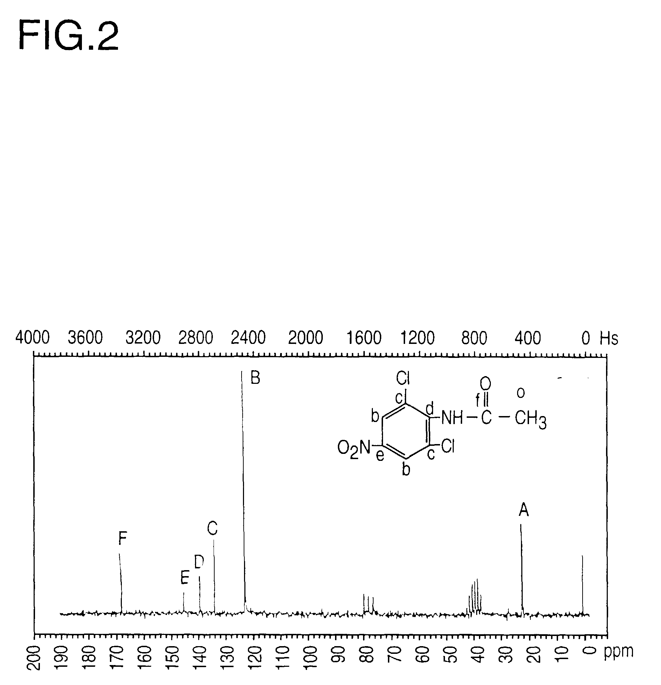

In Fig. 1 ist in Formel (I) die angenommene Struktur der untersuchten Verbindung gezeigt. Die Verschiebungen der sechs Kohlenstoffatome sind in dem ¹³C-NMR-Spektrum der Fig. 2 mit den Ziffern 1, 2/6, 3/5, 4 gekennzeichnet. Die zugehörigen Zahlen sind in Tabelle 5 in der Spalte "Experiment" angegeben.

Für das Atom Nr. 1 wurde ein viertes Meßsignal wie folgt ermittelt und in Tabelle 5 unter der Spaltenüberschrift "3-Sphären HOSE-Code mit Inkrement" wiedergegeben.

Zunächst wurden unter den bekannten, existierenden Verschiebungen für Verbindungen mit der Teilstruktur T1 und der jeweiligen Substitution Sv (in Tabelle 1 "R" genannt) aus einer Datenbank ermittelt und in Tabelle 1 in der Spalte 1 gezeigt. Sodann wurden für eine zweite Teilstruktur T2, wie sie in Fig. 1 unter (III) gezeigt ist (einfacher Benzolring) das Inkrement für die Substitution R an dieser zweiten Teilstruktur bestimmt. Konkret stellt der erste Wert (1) in der Zeile 1, Spalte 2 also die Differenz der gemessenen chemischen Verschiebungen für das C-Atom 1 in Benzol und Anilin dar. Diese Inkrementwerte stellen das zweite Meßwertsignal für die jeweilige Verbindung dar. Diese Inkrementwerte (2) in der Spalte 3 werden von den ersten Meßwertsignalen (1) der Spalte 2, den ersten Meßwertsignalen, abgezogen. Das Ergebnis (3) ist in Spalte 4 gezeigt. Die verschiedenen Verschiebungen, die sich auf dieselbe Teilstruktur beziehen (keine Substitution in Position 4), werden gemittelt. Das Ergebnis (4) ist in Spalte 5 gezeigt. Schließlich wird der Inkrementwert (5) für die Differenz der Verschiebung zwischen Nitrobenzol und Benzol als drittes Meßwertsignal ermittelt. Dieser Inkrementwert (5) ist in der Spalte 6 der Tabelle 1 gezeigt. Die Summe (137.7) aus zweitem und drittem Meßwertsignal ist in Spalte 7 gezeigt und stellt das vierte Meßwertsignal dar Dieser Wert ist auch in der zusammenfassenden Tabelle 5 Zeile 1 für das Atom 1 gezeigt.

Dieses Verfahren wird für die Atome 2, 3 und 4 wiederholt. Die Ergebnisse sind in den Tabellen 2, 3 und 4 dargestellt. Die jeweiligen Substituenten für die p-Position zu dem untersuchten C-Atom sind in den jeweiligen Spalten 1 angegeben.

In Tabelle 5 sind die Ergebnisse zum Vergleich dargestellt. Dabei wurden Die Abweichung absolut zwischen dem gemessenen Wert (Spalte 2) und dem 3-Sphären HOSE-Code-Wert allein (Spalte 4), zwischen dem gemessenen Wert (Spalte 2) und dem Inkrementwert allein (Spalte 3) und zwischen gemessenen Wert (Spalte 2) und dem vierten Meßwertsignal gemäß der Erfindung (Spalte 5) gebildet, wobei die Signale für die C-Atome 2 und 3 jeweils doppelt genommen wurden (C-Atome 6 und 5). Man sieht, daß die Abweichungssumme für das erfindungsgemäße Verfahren erheblich geringer ist als für eine Verifizierung mit entweder dem HOSE-Code allein oder mit lediglich den auf Benzol bezogenen Inkrementen. Dadurch wird die Zuverlässigkeit der Verifizierung oder des Analysenergebnisses erheblich gesteigert.

Tabellen 1 - 4: Daten zur Berechnung der chemischen Verschiebungen.
R¹ = "unbekannter" Rest (vierte Sphäre),
1 = experimentelle chemische Verschiebung mit Rest R,
2 = Inkrement nach Pretsch et al.,
3 = auf H normierte chemische Verschiebung,
4 = normierter Mittelwert,
5 = Inkrement für den Rest R der zu verifizierenden Verbindung,
6 = berechneter Wert.
   Alle Werte in ppm.

Spalte 3 = Spalte 1 - Spalte 2
Spalte 6 = Spalte 4 + Spalte 5

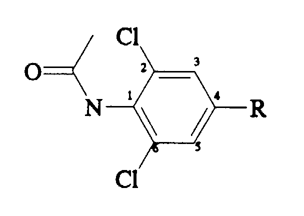

**Tabelle 1**

| **(Berechnung der chemischen Verschiebung von C-Atom 1)** | | | | | | |
|---|---|---|---|---|---|---|
| **R (an Atom 4)** | **1** | **2** | **3** | **4** | **5** | **6** |
| NH₂ | 120.3 | -9.5 | 129.8 | 131.7 | 6 | 137.7 |
| H | 130.6 | 0 | 130.6 | | | |
| H | 131.5 | 0 | 131.5 | | | |
| SO₂C | 137.7 | 5.1 | 132.6 | | | |
| NO₂ | 139.8 | 6.0 | 133.8 | | | |

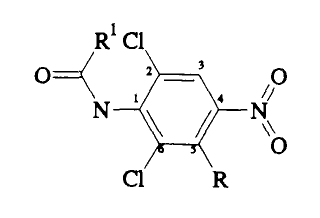

**Tabelle 2**

| **(Berechnung der chemischen Verschiebung von C-Atom 2)** | | | | | | |
|---|---|---|---|---|---|---|
| **R (an Atom 5)** | **1** | **2** | **3** | **4** | **5** | **6** |
| H | 134.1 | 0 | 134.1 | 134.2 | 0 | 134.2 |
| H | 134.2 | 0 | 134.2 | | | |
| H | 134.4* | 0 | 134.4 | | | |

| | | | | | | |
|---|---|---|---|---|---|---|
| * verschiedene Reste R¹ bedingen die unterschiedlichen Werte | | | | | | |

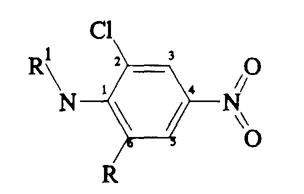

**Tabelle 3**

| **(Berechnung der chemischen Verschiebung von C-Atom 3)** | | | | | | |
|---|---|---|---|---|---|---|
| **R (an Atom 6)** | **1** | **2** | **3** | **4** | **5** | **6** |
| Cl | 123.0 | -2 | 125.0 | 124.7 | 0 | 124.7 |
| Cl | 123.7 | -2 | 125.7 | | | |
| Cl | 123.8 | -2 | 125.8 | | | |
| Cl | 124.0 | -2 | 126.0 | | | |
| H | 125.0 | 0 | 125.0 | | | |
| H | 125.6 | 0 | 125.6 | | | |
| H | 125.9 | 0 | 125.9 | | | |
| SO₃H | 127.3 | 3.8 | 123.5 | | | |
| SO₃H | 127.5 | 3.8 | 123.7 | | | |
| SO₃H | 127.8 | 3.8 | 124.0 | | | |
| NO₂ | 128.5 | 6 | 122.5 | | | |
| NO₂ | 129.6 | 6 | 123.6 | | | |

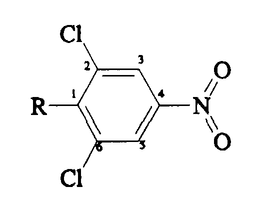

**Tabelle 4**

| **(Berechnung der chemischen Verschiebung von C-Atom 4)** | | | | | | |
|---|---|---|---|---|---|---|
| **R (an Atom 1)** | **1** | **2** | **3** | **4** | **5** | **6** |
| OH | 140.9 | -7.3 | 148.2 | 149.7 | 6 | 143.7 |
| OH | 141.1 | -7.3 | 148.4 | | | |
| OCH₂R | 143.4 | -8.1 | 151.5 | | | |
| F | 143.7 | -4.4 | 148.1 | | | |
| F | 144.0 | -4.4 | 148.4 | | | |
| F | 144.0 | -4.4 | 148.4 | | | |
| OPh | 144.8 | -5.3 | 150.1 | | | |
| NHCOCH₃ | 146.2 | -5.6 | 151.8 | | | |
| NHCOCH₃ | 146.2 | -5.6 | 151.8 | | | |
| I | 147.8 | -0.4 | 148.2 | | | |
| H | 149.2 | 0.0 | 149.2 | | | |
| H | 149.2 | 0.0 | 149.2 | | | |

**Tabelle 5**

| **(Zusammenstellung)** | | | | |
|---|---|---|---|---|
| **Atom** | **Experiment** | **Inkrement**^{**1**} | **3-Sphären HOSE-Code** | **erfindungsgemäß** |
| 1 | 139.8 | 147.7 | 132 | **137.7** |
| 2/6 | 134.4 | 128.0 | 134.2 | **134.2** |
| 3/5 | 123.3 | 122.3 | 125.8 | **124.7** |
| 4 | 145.7 | 146.8 | 145 | **143.7** |
| Σ | 543.2 | 23.8 | 13.9 | **5.7** |

### Beispiel 2

Es wurde wie in Beispiel 1 vorgegangen. Die untersuchte Verbindung war:

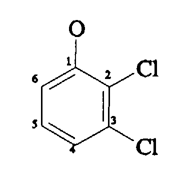

Die Ergebnisse waren hierbei:

Vergleich der experimentellen und berechneten chemischen Verschiebungen für 1 in ppm. (In der unteren Zeile ist die Summe der Abweichungen in ppm gezeigt.)

| **Atom** | **Experiment** | **Inkrement**^{**1**} | **3-Sphären HOSE-Code** | **erfindungsgemäß** |
|---|---|---|---|---|
| 1 | 152.7 | 159.1 | 154.3 | **153.6** |
| 2 | 119.1 | 121.4 | 120.7 | **119.4** |
| 3 | 132.7 | 135.6 | 134.9 | **133.4** |
| 4 | 122.3 | 122.9 | 121.1 | **122** |
| 5 | 128 | 129.4 | 128.7 | **127.9** |
| 6 | 114.5 | 115.2 | 114.3 | **114.5** |
| Σ | | 14.3 | 7.5 | **2.3** |

| | | | | |
|---|---|---|---|---|
| ¹ SpecTool Prof. Pretsch | | | | |

### Beispiel 3

Es wurde wie in Beispiel 1 vorgegangen. Die untersuchte Verbindung war:

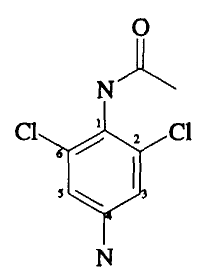

Die Ergebnisse waren hierbei:

Vergleich der experimentellen und berechneten chemischen Verschiebungen in ppm. (In der unteren Zeile ist die Summe der Abweichungen in ppm gezeigt.)

| **Atom** | **Experiment** | **Inkrement**^{**1**} | **3-Sphären HOSE-Code mit erster Korrektur** | **erfindungsgemäß** |
|---|---|---|---|---|
| 1 | 120.3 | 131.6 | 132 | **121.8** |
| 2/6 | 133.9 | 127.9 | 133.9 | **133.9** |
| 3/5 | 112.8 | 113.8 | 115.3 | **113.9** |
| 6 | 148.8 | 145.1 | 146 | **145** |
| Σ | | 29 | 19.5 | **7.5** |

| | | | | |
|---|---|---|---|---|
| ¹ SpecTool | | | | |

### Beispiel 4

Es wurde wie in Beispiel 1 vorgegangen. Die untersuchte Verbindung war:

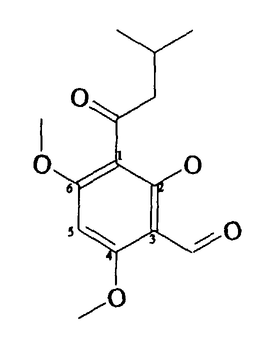

Die Ergebnisse waren hierbei:

| **Atom** | **Experiment** | **Inkrement** | **3-Sphären HOSE- Code mit erster Korrektur** | **erfindungsgemäß** |
|---|---|---|---|---|
| 1 | 106 | 103.0 | 121.0 | **103.1** |
| 2 | 165 | 160.6 | 170.4 | **164.5** |
| 3 | 111 | 101.7 | 108.2 | **103.2** |
| 4 | 165 | 170.0 | 163.8 | **167.5** |
| 5 | 86 | 92.7 | 92.2 | **87.6** |
| 6 | 163 | 170.3 | 163 | **163.6** |
| Δ _{(Exp-Vorhersage)} | | 36.9 | 30.6 | **15.9** |

| | | | | |
|---|---|---|---|---|
| ¹ SpecTool | | | | |

In allen Beispielen lieferte das erfindungsgemäße Verfahren erheblich bessere Annäherungen zwischen den tatsächlichen Meßwerten und den aus vorhandenen Daten vorhergesagten Werten, als die beiden anderen Methoden.

### Beispiel 5

In der folgenden Tabelle ist das Ergebnis des erfindungsgemäßen Verfahrens für ein nicht aromatisches Molekül gezeigt. Als Grundlage dienten hier 2 Sphären Teilstrukturen. Die Inkremente wurden wieder aus dem "Pretschbuch" entnommen. Für Atom Nr. 8 wurde aus einer Datenbank ein Inkrement erzeugt.

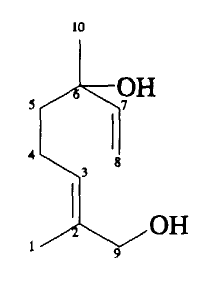

| **Atom** | **Experiment** | **Inkremente** | **2-Sphären HOSE-Code** | **erfindungsgemäß** |
|---|---|---|---|---|
| 1 | 13.7 | 13.1 | 18.8 | **14.9** |
| 2 | 134.9 | 138.0 | 135.2 | **134.7** |
| 3 | 125.7 | 125.0 | 123.2 | **124.9** |
| 4 | 22.4 | 18.5 | 27.9 | **20.7** |
| 5 | 41.8 | 43.8 | 36.1 | **42.2** |
| 6 | 73.3 | 72.2 | 73.0 | **71.3** |
| 7 | 144.9 | 140.6 | 143.7 | **145.6** |
| 8 | 111.8 | 114.4 | 116.1 | **111.6** |
| 9 | 68.3 | 72.9 | 62.7 | **64.2** |
| 10 | 27.7 | 27.7 | 26.6 | **26.6** |
| Δ/ΣC | | 2.24 | 3.15 | **1.23** |

Die Berechnung mit 3-Sphären HOSE-Codes liefert eine Abweichung von 0.97. Das erfindungsgemäße Verfahren ergibt somit aufgrund von 2-Sphären HOSE-Code-Werten und Inkrementwerten eine Annäherung, die praktisch ebenso gut ist, wie tatsächliche Messungen für entsprechende 3-Sphären Teilstrukturen. Es wird also gleichsam eine Sphäre gewonnen.

## Patentansprüche

1. Verfahren zur Strukturanalyse einer chemischen Verbindung durch Vergleich von mit der chemischen Verbindung gemessenen Meßwertsignalen und ermittelten Meßwertsignalen, dadurch gekennzeichnet, daß
a. eine angenommene Struktur eine erste Teilstruktur T1 mit einer Substitutionsposition und einer daran befindlichen Substitution Sa hat;
b. ein erstes Meßwertsignal für zumindest eine erste Verbindung einer zu der angenommenen Struktur ähnlichen Struktur mit derselben ersten Teilstruktur jedoch mit einem anderen Substituenten Sv an der Substitutionsposition ermittelt wird;
c. ein zweites Meßwertsignal ermittelt wird, das den Unterschied der Meßwerte einer zweiten Verbindung mit einer zweiten Teilstruktur T2, die in der ersten Teilstruktur T1 vorhanden ist und ebenfalls die Substitutionsposition aufweist und an dieser den Substituenten Sv trägt, und einer dritten Verbindung darstellt, die mit der zweiten Verbindung übereinstimmt, jedoch in der Substitutionsposition den Substituenten Sv nicht trägt;
d. ein drittes Meßwertsignal ermittelt wird, das den Unterschied der Meßwerte einer vierten Verbindung mit einer dritten Teilstruktur T3, die in der ersten Teilstruktur T1 vorhanden ist und ebenfalls die Substitutionsposition aufweist und an dieser den Substituenten Sa trägt, und einer fünften Verbindung darstellt, die mit der vierten Verbindung übereinstimmt, jedoch in der Substitutionsposition den Substituenten Sa nicht trägt;
e. ein viertes Meßwertsignal dadurch ermittelt wird, daß das erste Meßwertsignal mit Hilfe des zweiten Meßwertsignals und des dritten Meßwertsignals auf ein der angenommenen Struktur entsprechendes Meßwertsignal korrigiert wird;
f. das gemessene Meßwertsignal und das vierte Meßwertsignal miteinander verglichen werden.

2. Verfahren nach einem auf ein Verfahren zur Strukturanalyse einer chemischen Verbindung bezogenen Ansprüche, dadurch gekennzeichnet, daß das vierte Meßwertsignal dadurch ermittelt wird, daß
ea. zumindest ein erstes normiertes Meßwertsignal ermittelt wird, indem von dem entsprechenden ersten Meßwertsignal das Inkrement für die Substitution Sv entsprechend der Differenz der Meßwerte der zweiten und der dritten Verbindungen abgezogen wird;
eb. zu dem ersten normierten Meßwertsignal das Inkrement für die Substitution Sa entsprechend der Differenz der Meßwerte der vierten und fünften Verbindung addiert wird.

3. Verfahren nach einem der auf ein Verfahren zur Strukturanalyse gerichteten Ansprüche,
dadurch gekennzeichnet,
daß eine Mehrzahl von ersten Meßwertsignalen für eine entsprechende Mehrzahl verschiedener erster Verbindungen ermittelt wird,
daß für jede der verschiedenen ersten Verbindungen, für deren jeweilige Substitution Sv das zugehörige zweite Meßwertsignal ermittelt wird und von dem ersten Meßwertsignal abgezogen wird, und
daß aus den erhaltenen Einzelergebnissen ein Mittelwert als gemitteltes erstes normiertes Meßwertsignal gebildet wird, zu dem das dritte Meßwertsignal hinzugefügt wird, um das vierte Meßwertsignal zu erhalten.

4. Verfahren nach einem der auf ein Verfahren zur Strukturanalyse gerichteten Ansprüche, dadurch gekennzeichnet, daß daß man das erste Meßwertsignal und die Teilsignale des zweiten Meßwertsignals und des dritten Meßwertsignals bzw. die zweiten Meßwertsignale und die dritten Meßwertsignale selbst automatisch als digitales Signalwort aus einem Rechner aufgrund der Eingabe der Teilstrukturen und Substitutionen ermittelt.

5. Verfahren nach einem der auf ein Verfahren zur Strukturanalyse gerichteten Ansprüche, dadurch gekennzeichnet, daß die gemessenen Meßwertsignale, die ersten, zweiten und dritten Meßwertsignale bzw. deren Teilsignale ¹³C-NMR-Signale, insbesondere die jeweiligen chemischen Verschiebungen, für die entsprechenden Verbindungen darstellen.

6. Verfahren nach einem der auf ein Verfahren zur Strukturanalyse gerichteten Ansprüche, dadurch gekennzeichnet, daß die gemessenen Meßwerte, die ersten, zweiten und dritten Meßwertsignale bzw. deren Teilsignale ¹³C-NMR-Signale, insbesondere die jeweiligen chemischen Verschiebungen, für die entsprechenden Verbindungen darstellen, daß die Substitution Sa bezüglich des betrachteten C-Atoms eine entfernte Substitution, bevorzugt eine Substitution am vierten Atom ausgehend vom betrachteten Atom als dem ersten, insbesondere eine p-Substitution an einer aromatischen Verbindung darstellt.

7. Verfahren zur Strukturanalyse einer chemischen Verbindung, bei dem die chemische Verbindung einem Analyseverfahren zur Erzeugung eines Meßwertes als Grundlage der Erzeugung eines gemessenen Meßwertsignals unterzogen wird, bei dem das gemessene Meßwertsignal mit einem ermittelten Meßwertsignal verglichen wird, dadurch gekennzeichnet, daß unter Verwendung des gemessenen Meßwertsignals ein Verfahren nach einem der auf ein Verfahren zur Strukturanalyse gerichteten Ansprüche durchgeführt wird.
